# FASCICULE DE BREVET EUROPEEN

(11) **EP 3 631 484 B1**
(45) Date de publication et mention de la délivrance du brevet: **20.08.2025**
(21) Numéro de dépôt: 18727824.7
(22) Date de dépôt: 01.06.2018
(51) Int. Cl.: G01R 33/00, G01R 33/09

(54) **SYSTEME ET PROCEDE DE SUPPRESSION DU BRUIT BASSE FREQUENCE DE CAPTEURS MAGNETO-RESISTIFS**
SYSTEM UND VERFAHREN ZUR UNTERDRÜCKUNG VON NIEDERFREQUENZRAUSCHEN AUS MAGNETORESISTIVEN SENSOREN
SYSTEM AND METHOD FOR THE SUPPRESSION OF LOW-FREQUENCY NOISE FROM MAGNETORESISTIVE SENSORS

(30) Priorité: 02.06.2017 FR 1754901
(43) Date de publication de la demande: 08.04.2020
(73) Titulaire: Commissariat à l'Energie Atomique et aux Energies Alternatives, 75015 Paris (FR)
(72) Inventeur: SOLIGNAC, Aurélie, 91300 Massy (FR); FERMON, Claude, 91400 Orsay (FR); PANNETIER-LECOEUR, Myriam, 91440 Bures-sur-Yvette (FR); TRAUCHESSEC, Vincent, 75019 Paris (FR)
(74) Mandataire: Cabinet Camus Lebkiri
(86) Numéro de dépôt international: PCT/EP2018/064502
(87) Numéro de publication internationale: WO 2018/220193

(56) Documents cités:
- EP-A1- 2 165 206
- EP-A2- 2 165 210
- US-A1- 2008 224 695

## Description

### DOMAINE DE L'INVENTION

La présente invention concerne un système et un procédé de suppression du bruit basse fréquence d'un capteur de type magnéto-résistif. Les capteurs magnéto-résistifs couvrent les capteurs à magnétorésistance géante (« Giant Magnetoresistance » en anglais ou GMR) et les capteurs à magnétorésistance tunnel (« Tunnel Magnetoresistance » en anglais ou TMR), mais le procédé peut être étendu à tout capteur de champ magnétique de type magnéto-résistif.

### ART ANTERIEUR

Le bruit basse fréquence des capteurs magnéto-résistifs comme les GMRs ou TMRs est considéré aujourd'hui comme l'obstacle majeur pour leur utilisation dans certaines applications demandant une très grande détectivité dans les basses fréquences. Un exemple de ces applications est la mesure de champs magnétiques en milieu biologique, tels que les champs magnétiques associés aux signaux physiologiques et en particulier aux signaux neuronaux. Ces signaux varient lentement, avec des fréquences inférieures à 1 KHz et leur détection est affectée par le bruit basse fréquence du capteur utilisé lors de la mesure.

Pour les capteurs de type Magnetorésistance anisotrope (« Anisotropic Magnetoresistance » en anglais ou AMR) une méthode de changement de direction de courant permet de supprimer une partie de leur bruit en 1/f (voir par exemple I. Mateos et al. « Low-frequency noise characterization of a magnetic field monitoring system using an anisotropic magnetoresistance », publié dans Sensors and Actuators A, Volume 235, 2015). Cette technique ne peut pas être appliquée pour les GMRs et les TMRs car leur résistance et leur changement de résistance ne dépendent pas de la direction du courant.

Des techniques de modulation du champ vu par le capteur peuvent être appliquées. Ces techniques déplacent le point de fonctionnement du capteur hors de son bruit basse fréquence. Des exemples de telles techniques sont décrites dans les articles « Towards picoTesla Magnetic Field Detection Using a GMR-MEMS Hybrid Device » de A. Guedes et al., publié dans IEEE TRANSACTIONS ON MAGNETICS, Vol. 48, N. 11 Pages 4115-4118, 2012, et « Minimizing 1/f noise in magnetic sensor using a microelectromechanical system flux concentrator", de A. S. Edelstein et al., publié dans Journal of Applied Physics, Vol. 91, page 7795, 2002.

Ces publications proposent d'utiliser des concentrateurs de flux modulés en fréquence mais cette technique donne des résultats modestes et exige l'utilisation de MEMS (« Micro Electro-mechanical systems » en anglais) pour effectuer une modulation mécanique.

Dans le cas particulier de capteurs couplés à des boucles de courant supraconductrices, une modulation du supercourant peut relativement efficacement supprimer le bruit basse fréquence en déplaçant aussi le point de fonctionnement du capteur à plus haute fréquence. De telles solutions sont décrites est décrit dans les documents de brevets EP2165206 et EP2165210.

La publication US2008224695 A1 divulgue un autre capteur magnéto-résistif, comprenant des moyens de modulation pour réduire le bruit basse fréquence.

Toutefois ces techniques présentent plusieurs inconvénients tels que des difficultés de mise en œuvre, une limitation à la miniaturisation, une faible efficacité ou encore l'utilisation de matériaux supraconducteurs qui requièrent des conditions d'utilisation spécifiques et peuvent avoir des coûts élevés.

### RESUME DE L'INVENTION

L'invention vise à résoudre les problèmes mentionnés ci-dessus en proposant un système de suppression de bruit basse fréquence de capteurs magnéto-résistifs, ce système étant fiable, de faible encombrement et réalisable à partir de tout type de capteur magnéto-résistif.

A cette fin, un premier objet de l'invention est un système de suppression du bruit basse fréquence de capteurs magnéto-résistifs, ledit système de suppression comprenant :
- Un dispositif de mesure d'un champ magnétique, ledit dispositif comprenant au moins un capteur magnéto-résistif, ledit capteur magnéto-résistif ayant une première sensibilité à un premier point de fonctionnement et une deuxième sensibilité à un deuxième point de fonctionnement, la sensibilité au deuxième point de fonctionnement étant faible ou nulle ;
- Des moyens de modulation adaptés pour faire basculer le capteur magnéto-résistif du premier point de fonctionnement au deuxième point de fonctionnement et du deuxième point de fonctionnement au premier point de fonctionnement, lesdits moyens de modulation ayant une première configuration correspondant au premier point de fonctionnement et une deuxième configuration correspondant au deuxième point de fonctionnement ;
- Des moyens de traitement du signal issu du dispositif de mesure d'un champ magnétique, lesdits moyens de traitement étant adaptés pour réaliser une combinaison linéaire d'une première réponse du dispositif de mesure en présence du champ magnétique au premier point de fonctionnement correspondant à la première configuration des moyens de modulation et une deuxième réponse du dispositif de mesure en présence du champ magnétique au deuxième point de fonctionnement correspondant à la deuxième configuration des moyens de modulation.

On entend par capteur magnéto-résistif C tout élément ayant une résistance électrique dépendante du champ magnétique extérieur. En mesurant la variation de résistance aux bornes de l'élément C, il est possible de mesurer le champ magnétique extérieur. On entend par champ magnétique extérieur ou par champ magnétique le champ magnétique que l'on veut mesurer.

Les capteurs à magnétorésistance tunnel TMR et les capteurs à magnétorésistance géante GMR peuvent être utilisés dans le cadre de la présente invention.

Selon un mode de réalisation de l'invention, les capteurs magnétorésistifs GMR ou TMR utilisés sont des capteurs sans hystérésis.

Chaque capteur magnéto-résistif utilisé dans le cadre de la présente invention a des points de fonctionnements différents ayant une sensibilité différente.

On entend par moyens de modulation M des moyens permettant de modifier périodiquement la sensibilité des capteurs magnéto-résistifs utilisés. Les moyens M peuvent comprendre un générateur de courant ou de tension. La modulation effectuée par les moyens M est par exemple une variation périodique de la sensibilité des capteurs magnéto-résistifs C. La fréquence de cette modulation est supérieure à la fréquence du bruit basse fréquence que l'on veut éliminer.

On entend par sensibilité faible ou nulle du capteur magnéto-résistif C une sensibilité inférieure à 0.05%/mT dans le cas d'une GMR présentant une sensibilité typique de 1%/mT et 1%/mT pour une TMR présentant une sensibilité de 20%/mT
On entend par moyens de traitement du signal T des moyens utilisés pour sélectionner la réponse M1 du dispositif D quand le dispositif D est au premier point de fonctionnement et la réponse M2 du dispositif D quand le dispositif est au deuxième point de fonctionnement. Les moyens de traitement du signal T sont aussi adaptés pour réaliser une combinaison linéaire des réponses M1 et M2. Les moyens de traitement T peuvent comprendre des circuits analogiques, des circuits numériques ou un mélange de circuits analogiques et numériques.

Le bruit basse fréquence associé à un capteur magnéto-résistif C est, comme dans tous les conducteurs, un bruit de fluctuations de résistance. Par ailleurs, le champ extérieur crée lui aussi un changement de résistance. En cas d'utilisation d'un capteur magnéto-résistif pour mesurer un champ magnétique lentement variable, les deux variations de résistance ne peuvent donc pas être séparées par une seule mesure.

L'invention proposée se base sur un principe différent de ceux proposés jusqu'à maintenant. Elle consiste à faire osciller le capteur magnéto-résistif entre deux points de fonctionnement différents. Les deux points sont choisis de telle sorte que la réponse à un champ magnétique extérieur soit différente. La réponse du capteur au champ magnétique extérieur est aussi appelée sensibilité du capteur. L'oscillation du capteur entre deux points de fonctionnement différents est également appelée modulation de la sensibilité du capteur.

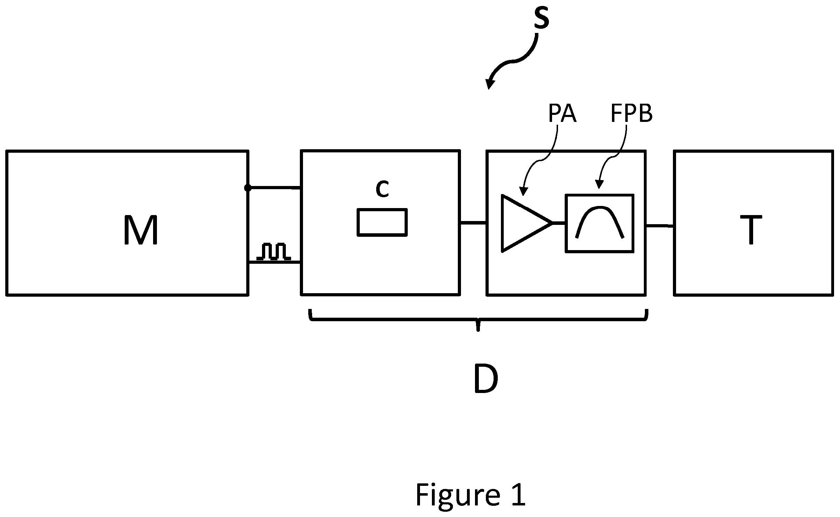

En d'autres termes, l'invention consiste à faire osciller le capteur entre ces deux points de mesure à une fréquence plus rapide que le domaine de bruit en 1/f comme indiqué sur la figure 1 et donc à mesurer à haute fréquence la réponse du capteur dans chaque état. On obtient ainsi deux courbes indépendantes, M1 et M2, les deux courbes étant fonctions du temps. Une combinaison linéaire de ces deux courbes permet d'obtenir une courbe uniquement dépendante du champ extérieur et une courbe donnant les fluctuations de résistance internes.

La reconstitution de ces deux courbes, M1 et M2, peut être faite soit numériquement, soit analogiquement.

L'invention sera d'autant plus efficace que les deux points correspondent à des sensibilités très différentes.

En particulier, le fait d'avoir choisi un deuxième point de fonctionnement ayant sensibilité faible ou nulle permet de ne retenir, dans la mesure M2 correspondant à ce point de fonctionnement, que les variations de résistance dues majoritairement au bruit basse fréquence, le capteur n'étant plus sensible au champ extérieur B. Cette mesure peut ensuite être soustraite à la mesure M1 réalisée au premier point de fonctionnement, de sorte à isoler les fluctuations de résistance dues essentiellement à la variation du champ magnétique extérieur B et correspondant donc à une mesure de ce champ extérieur.

Le dispositif selon l'invention permet donc de séparer les variations de résistance d'un capteur magnéto-résistif dues au bruit basse fréquence et les variations de résistances dues à la variation du champ magnétique extérieur B. Autrement dit, le dispositif selon l'invention permet de supprimer le bruit basse fréquence de capteurs magnéto-résistifs.

Le dispositif selon l'invention peut également présenter une ou plusieurs des caractéristiques ci-dessous, considérées individuellement ou selon toutes les combinaisons techniquement possibles, tant qu'elles entrent dans la portée des revendications annexées :
- le dispositif D de mesure d'un champ magnétique B comprend deux capteurs magnéto-résistifs 301, 302 disposés selon un montage en demi-pont et un préamplificateur PA bas bruit, les deux capteurs magnéto-résistifs ayant une réponse au champ magnétique inversée, le montage en demi-pont comprenant un premier bras B1 et un deuxième bras B2, les deux bras étant connectés en parallèle, chacun des bras comprenant une résistance R et un des capteurs magnéto-résistifs 301,302, le montage en demi-pont comprenant en outre une première V+ et une deuxième V-sortie, les deux sorties étant connectées au préamplificateur PA bas bruit, chaque sortie V+, V- étant le point de jonction entre une des résistances R et un des capteurs magnéto-résistifs 301, 302 ;
- le système de mesure D comprend une source tension continue V pour l'alimentation du montage en demi-pont, la tension continue V étant connectée au point de jonction entre les deux résistances R ou au point de jonction entre les deux capteurs magnéto-résistifs 301, 302 ;
- le dispositif de mesure D comprend un premier 401, 401a et un deuxième 402, 402a couple de capteurs magnéto-résistifs et un préamplificateur PA bas bruit, les capteurs du premier couple 401, 401a ayant une réponse inversée par rapport aux capteurs du deuxième couple 402, 402a, les capteurs magnéto-résistifs 401, 401a, 402, 402a étant disposés selon un montage en pont, le montage en pont comprenant un premier bras B1 et un deuxième bras B2, les deux bras étant connectés en parallèle, chacun de bras comprenant un capteur magnéto-résistif du premier couple 401,401a et un capteur magnéto-résistif du deuxième couple 402, 402a, le montage en pont comprenant en outre une première V+ et une deuxième V- sortie, les deux sorties étant connectées au préamplificateur bas bruit, chaque sortie V+, V- étant le point de jonction entre un capteur magnéto-résistif du premier couple 401, 401a et un capteur magnéto-résistif du deuxième couple 402, 402a ;
- le système de mesure D comprend une source de tension continue V pour l'alimentation du montage en pont, la source de tension continue V étant connectée à un point de jonction entre un capteur magnéto-résistif du premier couple et un capteur magnéto-résistif du deuxième couple ;
- le dispositif D de mesure comprend des moyens de chauffage local de sorte à retourner la couche de référence 703, 704 d'au moins un des capteurs magnéto-résistifs ;
- le dispositif D de mesure comprend des lignes de courant 301, 302, 403, 404 pour appliquer un champ magnétique dans le plan des couches des capteurs magnéto-résistifs, de sorte qu'en présence du courant dans les lignes chaque capteur magnéto-résistif C est au deuxième point de fonctionnement 202 et en absence de courant dans les lignes chaque capteur magnéto-résistif C est au premier point de fonctionnement 201 ;
- quand le courant est appliqué, les capteurs magnéto-résistifs ayant des réponses inversées sont au deuxième point de fonctionnement (202) ayant sensibilité faible ou nulle (Ssat), tout en ayant la même résistance ;
- les moyens de modulation M comprennent une horloge générale à haute fréquence pour la génération d'un signal L1/L2 de commutation entre le premier point de fonctionnement 201 et le deuxième point de fonctionnement 202 ;
- le signal de commutation L1/L2 comprend des impulsions de courant circulant dans les lignes de courant 301, 302, 403, 404 pour la commutation de chaque capteur magnéto-résistif entre le premier point de fonctionnement 201 et le deuxième point de fonctionnement 202 ;
- les moyens de traitement T du signal issu du dispositif D de mesure d'un champ magnétique B comprennent un dispositif d'acquisition numérique rapide du signal issu du préamplificateur PA ;
- les moyens de traitement T du signal issu du dispositif D de mesure d'un champ magnétique B comprennent :
   - Un premier circuit Sample and Hold destiné à enregistrer le signal M1 mesuré par le dispositif D de mesure au premier point de fonctionnement 201 ;
   - Un deuxième circuit Sample and Hold destiné à enregistrer le signal M2 mesuré par le dispositif D de mesure au deuxième point de fonctionnement 202 ;
   - Un système d'acquisition numérique DSP ou analogique 1301 pour la combinaison linéaire des signaux issus du premier et deuxième circuit Sample and Hold ;
- l'horloge générale génère en outre un premier signal SH1 de contrôle du premier circuit Sample and Hold et un deuxième signal SH2 de contrôle du deuxième circuit Sample and Hold.

Un autre objet de l'invention est un procédé de suppression de bruit basse fréquence associé à la mesure d'un champ magnétique par un dispositif de mesure comprenant au moins un capteur magnéto-résistif, ledit procédé comprenant les étapes suivantes :
- Identifier un premier et un deuxième point de fonctionnement de l'au moins un capteur magnéto-résistif, le capteur magnéto-résistif ayant une première sensibilité au premier point de fonctionnement et une deuxième sensibilité au deuxième point de fonctionnement, la sensibilité au deuxième point de fonctionnement étant faible ou nulle ;
- Moduler la sensibilité du capteur magnéto-résistif en faisant basculer le capteur magnéto-résistif du premier point de fonctionnement ayant la première sensibilité au deuxième point de fonctionnement ayant la deuxième sensibilité et du deuxième point de fonctionnement au premier point de fonctionnement ;
- Lors de la modulation, mesurer une première réponse du dispositif de mesure D en présence du champ magnétique au premier point de fonctionnement S1 et une deuxième réponse M2 du dispositif de mesure en présence du champ magnétique au deuxième point de fonctionnement ;
- Calculer une combinaison linéaire de la première réponse M1 et de la deuxième réponse M2 du système de mesure D.

La première étape du procédé selon l'invention permet d'identifier les deux points de fonctionnement des capteurs magnéto-résistifs compris dans le dispositif D, les deux points de fonctionnement ayant deux sensibilités différentes.

Avantageusement, le deuxième point de fonctionnement est choisi de sorte à avoir une sensibilité au champ magnétique extérieur faible ou nulle. Cela permet de différencier les fluctuations de résistance dues au bruit basse fréquence du capteur C des fluctuations de résistance dues au champ magnétique extérieur.

La sensibilité du capteur est ensuite modulée, par exemple à l'aide des moyens de modulation M, de sorte à faire basculer les capteurs magnéto-résistifs du dispositif D entre les deux points de fonctionnement.

Il est donc possible de mesurer la réponse du dispositif D au premier et au deuxième point de fonctionnement, de sorte à identifier les fluctuations de résistance dues majoritairement au bruit basse fréquence en condition de sensibilité faible ou nulle des éléments magnéto-résistifs.

Le procédé selon l'invention peut également présenter une ou plusieurs des caractéristiques ci-dessous, considérées individuellement ou selon toutes les combinaisons techniquement possibles, tant qu'elles entrent dans la portée des revendications annexées :
- la fréquence de modulation de la sensibilité du capteur est supérieure à la fréquence 101 à laquelle le bruit basse fréquence devient inférieur au bruit thermique associé au capteur C ;
- la fréquence de modulation MOD de la sensibilité du capteur est au moins deux fois supérieure à la fréquence 101 à laquelle le bruit basse fréquence devient inférieur au bruit thermique associé au capteur C ;
- le dispositif de mesure D comprend deux capteurs magnéto-résistifs 301, 302 disposés selon un montage en demi-pont et un préamplificateur, les deux capteurs magnéto-résistifs ayant une réponse au champ magnétique inversée, le montage en demi-pont comprenant un premier bras B1 et un deuxième bras B2, les deux bras étant connectés en parallèle, chacun de bras comprenant une résistance R et un des capteurs magnéto-résistifs 301, 302, le montage en demi-pont comprenant en outre une première V+ et une deuxième V- sortie, les deux sorties étant connectées au préamplificateur bas bruit, chaque sortie V+, V- étant le point de jonction entre une des résistances R et un des capteurs magnéto-résistifs 301, 302 ;
- le dispositif de mesure D comprend un premier 401, 401a et un deuxième 402, 402a couple de capteurs magnéto-résistifs et un préamplificateur bas bruit, les capteurs du premier couple 401, 401a ayant une réponse inversée par rapport aux capteurs du deuxième couple 402, 402a les capteurs magnéto-résistifs 401, 401a, 402, 402a étant disposés selon un montage en pont, le montage en pont comprenant un premier bras B1 et un deuxième bras B2, les deux bras étant connectés en parallèle, chacun de bras comprenant un capteur magnéto-résistif du premier couple 401, 401a et un capteur magnéto-résistif du deuxième couple 402, 402a, le montage en pont comprenant en outre une première V+ et une deuxième V- sortie, les deux sorties étant connectées au préamplificateur bas bruit, chaque sortie V+, V- étant le point de jonction entre un capteur magnéto-résistif du premier couple 401, 401a et un capteur magnéto-résistif du deuxième couple 402, 402a ;
- l'étape MOD de modulation de la sensibilité d'au moins un capteur magnéto-résistif est réalisée à l'aide d'une ligne de courant disposée à proximité de l'au moins un capteur magnéto-résistif et adaptée à générer un champ magnétique dans le plan des couches du capteur magnéto-résistif, de sorte à saturer le capteur magnéto-résistif en réduisant ou annulant sa sensibilité quand le capteur se trouve au deuxième point de fonctionnement ;
- l'étape de mesure MES de la première réponse M1 du dispositif D de mesure et de la deuxième réponse M2 du dispositif D de mesure est réalisée à l'aide d'un système d'acquisition numérique ou analogique 1101 ;
- l'étape de combinaison linéaire LIN est réalisée à l'aide d'un système d'acquisition numérique ou analogique.

### LISTE DES FIGURES

D'autres caractéristiques et avantages de l'invention ressortiront clairement de la description qui en est donnée ci-dessous, à titre indicatif et nullement limitatif, en référence aux figures annexées, parmi lesquelles :
- la figure 1 montre un schéma du système S de réduction du bruit basse fréquence selon un objet de l'invention ;
- la figure 2 montre la densité spectrale de bruit en 1/f ou bruit basse fréquence ;
- la figure 3 montre une réponse typique d'un capteur GMR ou TMR ;
- la figure 4 montre un premier exemple de dispositif de mesure D associé au système S de réduction du bruit basse fréquence tel que donné à la figure 1 ; dans ce cas un montage en demi-pont avec deux éléments magnéto-résistifs est représenté ;
- la figure 5 montre un deuxième exemple de dispositif de mesure D associé au système S de réduction du bruit basse fréquence tel que donné à la figure 1 ; dans ce cas un montage en pont complet avec quatre éléments magnéto-résistifs est représenté ;
- la figure 6 montre un exemple physique de capteur GMR en forme de C, avec des lignes de courant intégrées et permettant d'appliquer un champ magnétique pour la modulation de la sensibilité du capteur ; ce système peut être utilisé dans le dispositif D de mesure du champ magnétique tel que donné à la figure 1 ;
- la figure 7 montre un exemple de courbe temporelle de sortie d'un pont tel que donné à la figure 5 ;
- la figure 8 montre un empilement typique d'une magnétorésistance tunnel TMR ; un tel capteur peut être utilisé dans le dispositif D illustré à la figure 1 ;
- la figure 9 illustre schématiquement un mode de réalisation du système S de suppression du bruit basse fréquence avec un traitement numérique du signal issus du dispositif D de mesure ;
- la figure 10 montre le schéma électronique d'un mode de réalisation du système S de suppression du bruit basse fréquence permettant d'obtenir les deux courbes M1 et M2 de façon analogique et de réaliser une combinaison linéaire digitale ;
- la figure 11 montre le schéma électronique d'un mode de réalisation du système S de suppression du bruit basse fréquence permettant d'obtenir les deux courbes M1 et M2 de façon analogique et de réaliser une combinaison linéaire analogique ;
- la figure 12 montre un exemple de signaux issus des moyens de modulation M et permettant de moduler la sensibilité des capteurs GMR ou TMR ; la figure 12 montre également les signaux utilisés pour piloter les circuits de traitement analogique des signaux M1 et M2 ;
- la figure 13 montre les étapes du procédé de mise en œuvre du système de réduction du bruit selon l'invention.

### DESCRIPTION DETAILLEE DE L'INVENTION

La figure 1 montre un exemple du système S de réduction du bruit basse fréquence selon l'invention. Le système S comprend :
- des moyens de modulation M utilisés pour moduler la sensibilité d'au moins un capteur magnéto-résistif ; les moyens de modulation comprennent par exemple un générateur de tension continue V et un générateur d'impulsions de courant ou de tension GI ;
- un dispositif D de mesure d'un champ magnétique extérieur B ; le dispositif D comprend au moins un capteur magnéto-résistif C, un amplificateur bas-bruit PA pour l'amplification du signal issu du capteur magnéto-résistif C et un filtre passe bande FPB pour éliminer les composantes basses et hautes fréquences du signal mesuré par D ; il est important de noter que chaque capteur magnéto-résistif faisant partie du dispositif D a des points de fonctionnement différents avec des sensibilités au champ magnétique extérieur B différentes ; le dispositif D fournit une première mesure M1 et une deuxième mesure M2 issue du dispositif D ;
- un dispositif de traitement du signal T pour enregistrer les deux mesures M1 et M2 et/ou réaliser la combinaison linéaire de la première mesure M1 et de la deuxième mesure M2.

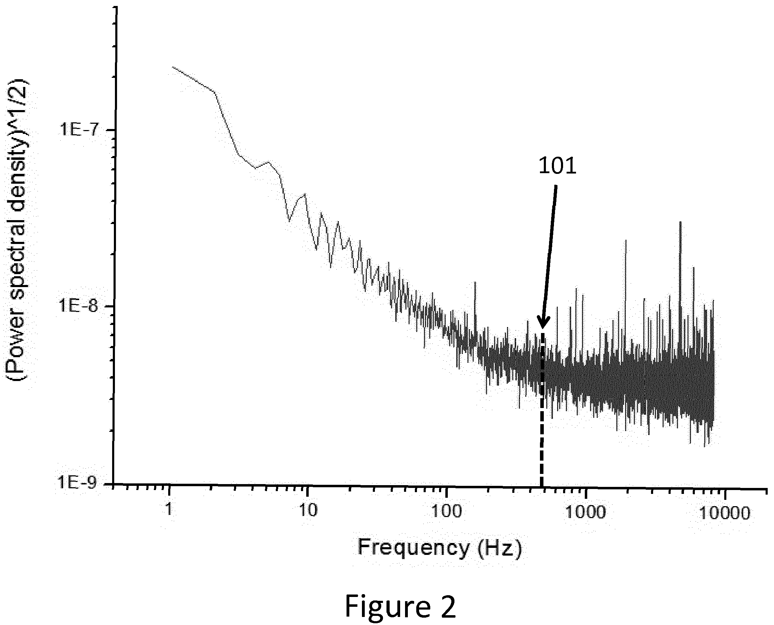

La figure 2 montre un exemple de densité spectrale de bruit en 1/f d'un capteur magnéto-résistif. Sur cette figure on voit que le bruit basse fréquence devient inférieur au bruit thermique à partir de la fréquence 101. Dans ce cas, il faut que la fréquence d'oscillation entre les deux points de fonctionnement soit supérieure à la fréquence 101 et si cela est possible, au moins deux fois supérieure à la fréquence correspondant au point 101.

La fréquence d'oscillation entre les deux points de fonctionnement ayant sensibilités différentes est également appelée fréquence de modulation de la sensibilité des capteurs magnéto-résistifs.

Avantageusement, il vaut mieux choisir 'une fréquence de modulation suffisamment élevée, c'est-à-dire au-delà de la fréquence où les fluctuations de résistance deviennent égales au bruit thermique.

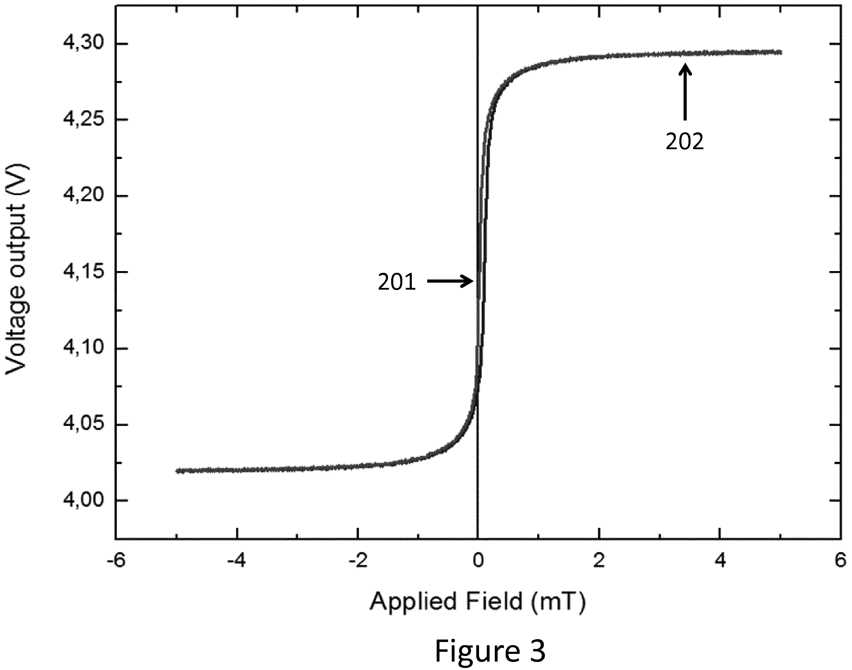

La figure 3 montre la réponse typique d'un capteur magnéto-résistif de type GMR ou TRM linéarisé pour avoir une réponse correcte en champ nul. L'axe des ordonnés représente la tension mesurée aux bornes du capteur magnéto-résistif et l'axe des abscisses représente le champ magnétique extérieur. Les deux points de fonctionnement 201 et 202 sont deux points ayant une première sensibilité S1 et une deuxième sensibilité S2.

La sensibilité étant proportionnelle à la pente de la courbe illustré à la figure 3, on voit que le point 201 correspond à une sensibilité S1 élevée et le point S2 à une sensibilité faible ou nulle. En particulier, le point 201 se trouve dans la zone de fonctionnement ou zone de sensibilité du capteur. Le point 202 se trouve dans la zone de saturation où sa sensibilité devient faible ou nulle. Le système S selon l'invention permet de faire osciller le capteur magnéto-résistif entre les deux points 201 et 202.

Par exemple, lorsqu'un champ magnétique appliqué sur chaque élément magnéto-résistif dépasse une valeur Hs dans le plan de l'axe de sensibilité de l'empilement, le capteur est dans la région de saturation.

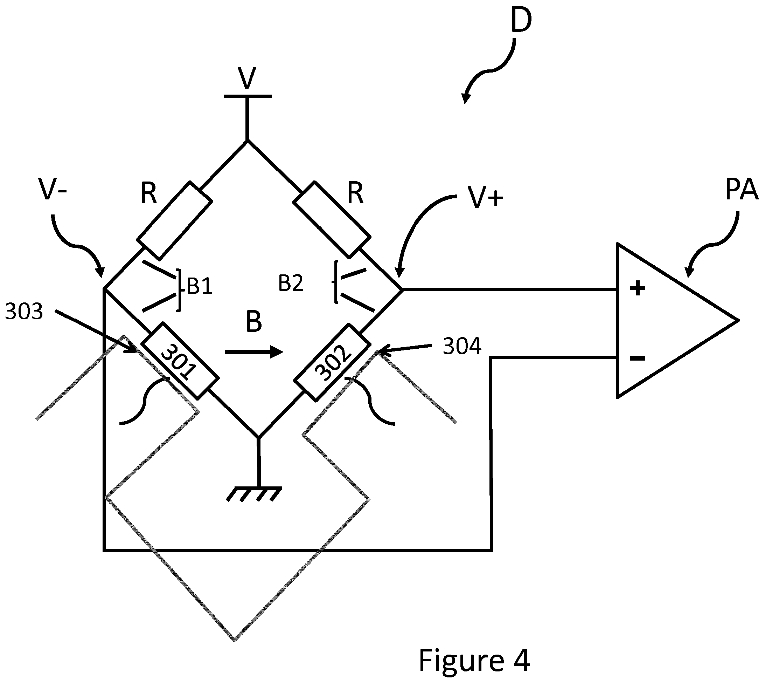

La figure 4 montre un premier mode de réalisation du dispositif de mesure D du système S selon l'invention. Selon ce mode de réalisation le dispositif de mesure D comprend deux capteurs magnéto-résistifs 301 et 302 et deux résistances R identiques. Ces quatre éléments sont connectés selon un montage en demi-pont illustré à la figure 4.

En particulier le montage en demi-pont comprend une tension V d'alimentation connectée à un premier bras B1 et à un deuxième bras B2. Les deux bras sont connectés en parallèle. L'extrémité des bras B1 et B2 opposée à l'extrémité connectée à la tension V est connectée à la masse. Chacun des deux bras B1 et B2 comprend une résistance R et un élément magnéto-résistif. Dans l'exemple illustré à la figure 4, la tension d'alimentation V est connectée au point de jonction entre les deux résistances R. Alternativement, la tension V peut être connectée au point de jonction entre les deux capteurs magnéto-résistifs 301 et 302.

Chaque bras B1, B2 du montage de la figure 4 comprend une sortie V-, V+. Les deux sorties V-, V+ sont connectées à un préamplificateur bas bruit PA.

Les deux capteurs magnéto-résistif 301 et 302 ont une réponse au champ extérieur inversée. Autrement dit, sous l'action du champ magnétique extérieur et uniforme dans le volume occupé par le pont de la figure 4, une augmentation de magnétorésistance du premier capteur magnéto-résistif 301 correspond à une diminution de magnétorésistance du deuxième capteur magnéto-résistif 302.

Avantageusement, cela permet de mesurer une différence de potentiel entre les deux sorties V+ et V- qui est proportionnel au champ magnétique extérieur à mesurer.

Pour mettre en œuvre l'invention, il est nécessaire de moduler la sensibilité des capteurs magnéto-résistifs 301 et 302 entre le premier point de fonctionnement 201 ayant une sensibilité élevée S1 et le deuxième point de fonctionnement Ssat ayant sensibilité nulle. Cette modulation peut être obtenue en appliquant un champ magnétique suffisamment intense dans le plan des couches des capteurs magnéto-résistifs pour saturer les capteurs en les déplaçant dans la zone de saturation.

Les deux éléments 301 et 302 ayant une réponse inversée, le champ de saturation à appliquer sur chaque élément doit être inversé.

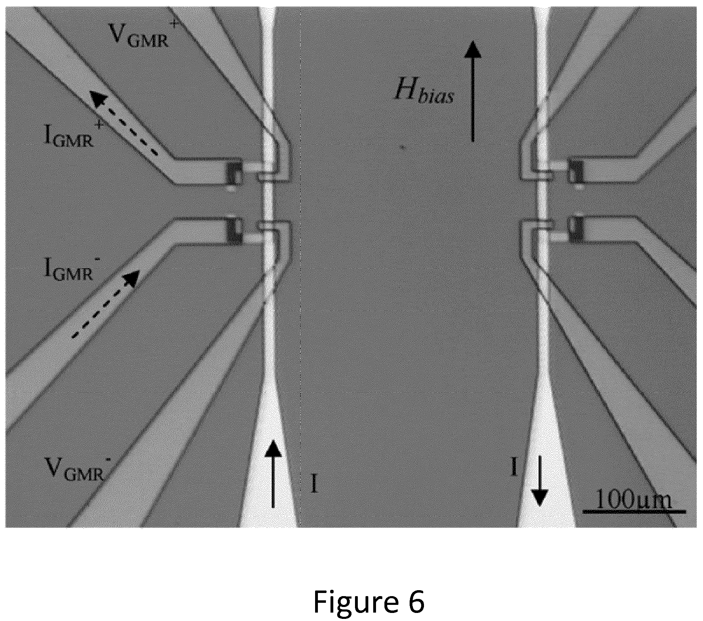

Selon le mode de réalisation illustré à la figure 4, l'application du champ magnétique de saturation sur chaque élément 301, 302 est réalisée grâce aux lignes de courant 303 et 304. L'oscillation champ fort-champ nul se fait par des lignes de courant 303 et 304 intégrées comme proposé par exemple sur la figure 6. Le courant doit être choisi de telle façon que le capteur sature dans le mode courant appliqué c'est-à-dire qu'il permet de créer un champ magnétique sur les éléments plus grand que Hs+Hp où Hp est la plage de fonctionnement en champ souhaitée pour le capteur et Hs est le champ de saturation de l'élément. Comme le courant appliqué pour un même champ va varier inversement à la largeur des capteurs, il est préférable d'utiliser des capteurs présentant une faible dimension latérale typiquement de l'ordre de 3 à 5µm mais des largeurs en dehors de cette plage peuvent être choisies.

Le premier point de fonctionnement du capteur correspond à un courant dans les lignes nul. Le deuxième point de fonctionnement correspond à un courant dans les lignes qui sature les capteurs en créant un champ magnétique de saturation suffisamment intense. Il est à souligner qu'il faut appliquer le courant dans les lignes de telle sorte que le deuxième point de fonctionnement 202 corresponde à la même valeur de résistance pour les deux capteurs et doit donc être physiquement inversé vu leur réponse inversée. L'agencement des lignes de courant 303, 304 illustré à la figure 4 permet pour un même courant circulant dans les lignes d'obtenir des champs magnétique inversés en correspondance des éléments 301 et 302 ayant des réponses inversées. Il peut y avoir des petits transitoires rapides lors de l'application du courant et sa suppression.

Avantageusement, les lignes de courant 303 et 304 peuvent être intégrées sur le dispositif de mesure D, en réduisant l'encombrement du système de réduction du bruit basse fréquence S.

Alternativement, si les éléments 301 et 302 sont suffisamment espacés, deux bobines indépendantes peuvent être utilisées pour l'application du champ magnétique de saturation.

Avantageusement, le montage en demi-pont permet d'avoir une sortie indépendante du point de fonctionnement des capteurs magnéto-résistifs. Autrement dit, la tension différentielle en sortie du pont de la figure 4 quand les éléments magnéto-résistifs sont au premier point de fonctionnement 201 est proche de la tension différentielle quand les éléments magnéto-résistif sont au point de saturation 202.

Cette configuration est très avantageuse car dans les deux cas il est possible d'amplifier la tension de sortie du pont sans saturer le préamplificateur bas bruit PA.

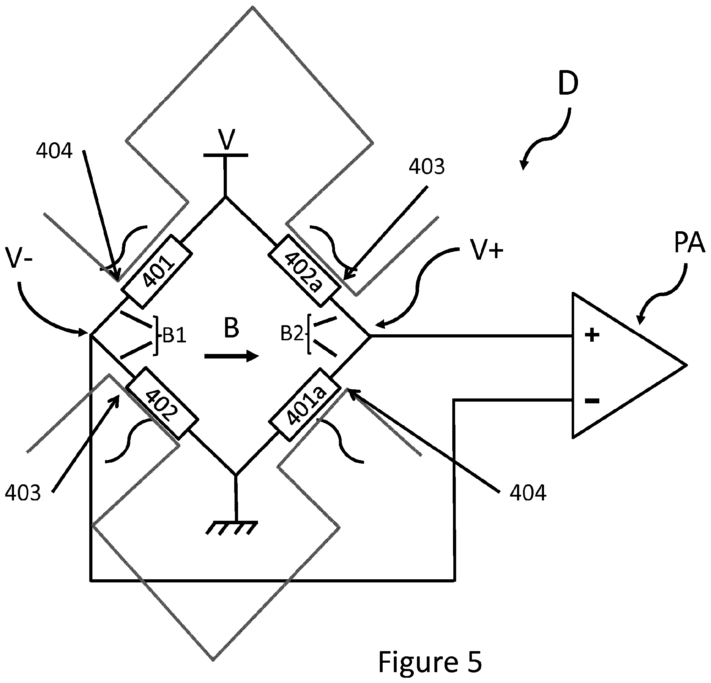

La figure 5 montre un deuxième mode de réalisation du dispositif de mesure D pour le système S de réduction de bruit basse fréquence. Dans ce cas on a un montage en pont complet avec quatre éléments magnéto-résistifs. Les éléments 401 et 401a ont une réponse inversée par rapport aux éléments 402 et 402a.

Le fonctionnement du circuit de la figure 5 est similaire au fonctionnement de la figure 4. Le champ de saturation des éléments magnéto-résistifs peut être appliqué grâce aux lignes de courant 403 et 404. Ces lignes de courant peuvent être intégrées au dispositif D pour réduire l'encombrement du système S.

Alternativement, si les éléments 401, 401a, 402, 402a sont suffisamment espacés, quatre bobines indépendantes peuvent être utilisées pour générer le champ magnétique pour saturer les capteurs.

Avantageusement, le montage en pont permet d'une part d'avoir une sortie indépendante du point de fonctionnement des capteurs magnéto-résistifs et d'autre part permet de gagner un facteur 2 sur l'amplitude de sortie.

A la fois dans le cas du montage en demi-pont illustré à la figure 4 et dans le cas du montage en pont illustré à la figure 5, les éléments magnéto-résistifs doivent avoir une réponse inversée. Cette réponse inversée peut être obtenue suivant des procédés déjà connus : le premier consiste à monter 4 capteurs identiques mais physiquement renversés. Cette méthode est simple à utiliser mais nécessite d'avoir deux dies de silicium indépendants et donc présente un coût commercial plus important. Le second procédé consiste à retourner par un moyen de chauffage local la couche de référence des deux éléments magnétoresistifs 402, 402a par un chauffage local sous champ. Le troisième procédé consiste à déposer deux empilements légèrement différents qui ont des réponses inversées mais très proches. Dans un mode préférentiel, nous appliquons le deuxième procédé qui permet d'avoir un procédé industrialisable à faible coût.

La figure 6 montre un exemple physique de capteur GMR en forme de C avec des lignes de courant intégrées permettant de créer un champ suffisant pour saturer les capteurs tout en ayant une consommation de courant faible.

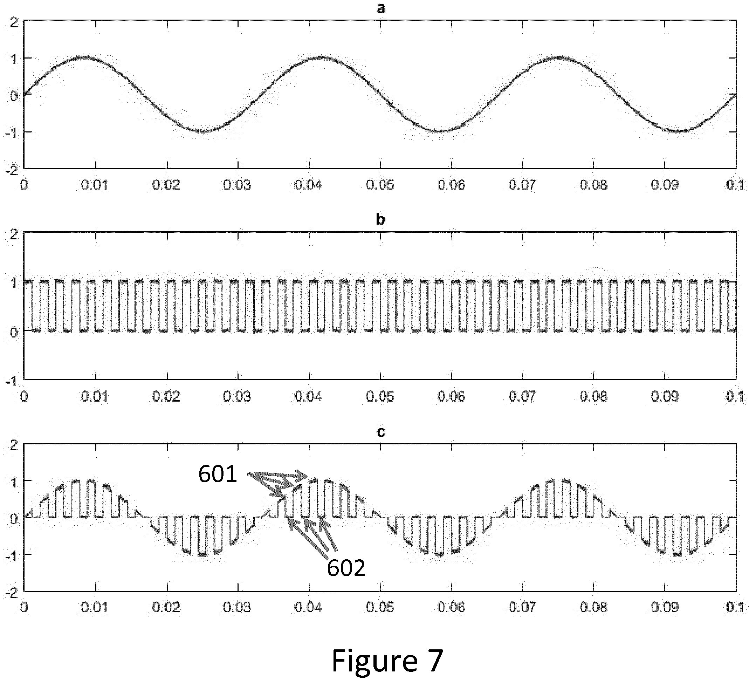

La figure 7a montre un exemple de courbe temporelle de sortie d'un dispositif D tel que celui représenté à la figure 5. Cette courbe représente la tension de sortie du pont de la figure 5, le pont étant soumis à un champ magnétique extérieur sinusoïdal. La courbe 7b montre le courant dans les lignes de courant 403 et 404. Le courant envoyé dans les lignes de courant correspond au champ magnétique appliqué aux capteurs 401, 401a, 402 et 402a et capable de les saturer. En d'autres termes, quand le courant dans les lignes est nul, les capteurs sont au premier point de fonctionnement 201 avec une sensibilité élevée.

En présence de courant dans les lignes, le champ magnétique appliqué sature les capteurs C en déplaçant leur point de fonctionnement aux point 202 avec une sensibilité faible ou nulle.

Avantageusement, le courant dans les lignes de courant 403, 404 est par exemple contrôlé grâce aux moyens de modulation M de figure 1. L'absence de courant dans les lignes correspond à la première configuration des moyens de modulation M et la présence de courant dans les lignes correspond à la deuxième configuration des moyens de modulation M.

Avantageusement, le point de fonctionnement des éléments magnéto-résistifs du dispositif de mesure D peut être contrôlé grâce aux moyens de modulations M.

La figure 7c donne la sortie du pont en présence du champ magnétique extérieur et de l'excitation de courant de la figure 7b. Sur cette courbe on voit qu'en absence de courant dans les lignes de courant 403, 404 le dispositif D est sensible au champ magnétique extérieur et la sortie du pont suit les variations de ce champ. Il s'agit, par exemple de la mesure au point 601 de figure 7b.

En présence de courant dans les lignes de courant 403, 404 les capteurs magnéto-résistifs sont saturés et le dispositif D n'est plus sensible au champ magnétique extérieur. Il s'agit par exemple de la mesure au point 602.

Le dispositif D du système S selon l'invention est donc capable de fournir une première mesure M1 correspondant au premier point de fonctionnement des capteurs magnéto-résistifs. Cette première mesure M1 correspond aux points de type 601 sur la figure 7c. Le dispositif D est aussi capable de fournir une deuxième mesure M2 correspondant au deuxième point de fonctionnement des capteurs magnéto-résistifs. La deuxième mesure M2 correspond aux points de type 602 sur la figure 7c.

Avantageusement, la deuxième mesure M2 associé aux points de type 602 de la figure 7c contient les fluctuations de résistances due majoritairement au bruit basse fréquence des éléments magnéto-résistifs.

En réalisant une combinaison linéaire des mesures M1 et M2 il est donc possible d'éliminer le bruit basse fréquence.

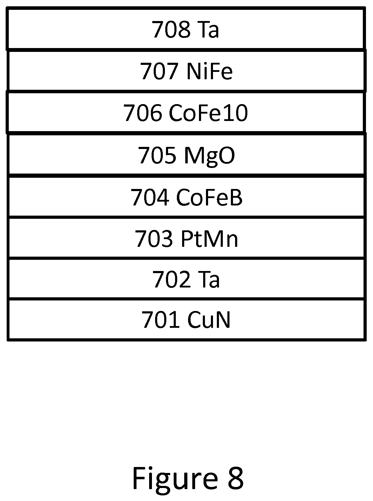

La figure 8 montre un empilement typique d'une magnétorésistance tunnel TMR. La couche 701, souvent un alliage de Cu de type CuN sert d'électrode inférieure. La couche 702 sert de couche de croissance. Les couches 703 un antiferromagnetique de type PtMn ou IrMn couplé à une couche de type CoFeB 704 servent de référence. La barriere est formée de Al2O3 ou préférentiellement MgO 705. Les couches 706 et 707 forment une couche libre classique. C'est-à-dire une couche qui suit le champ extérieur. La couche 708 sert de protection et de départ pour le contact supérieur de la jonction tunnel.

Il existe de nombreuses variantes d'empilement connus de la littérature.

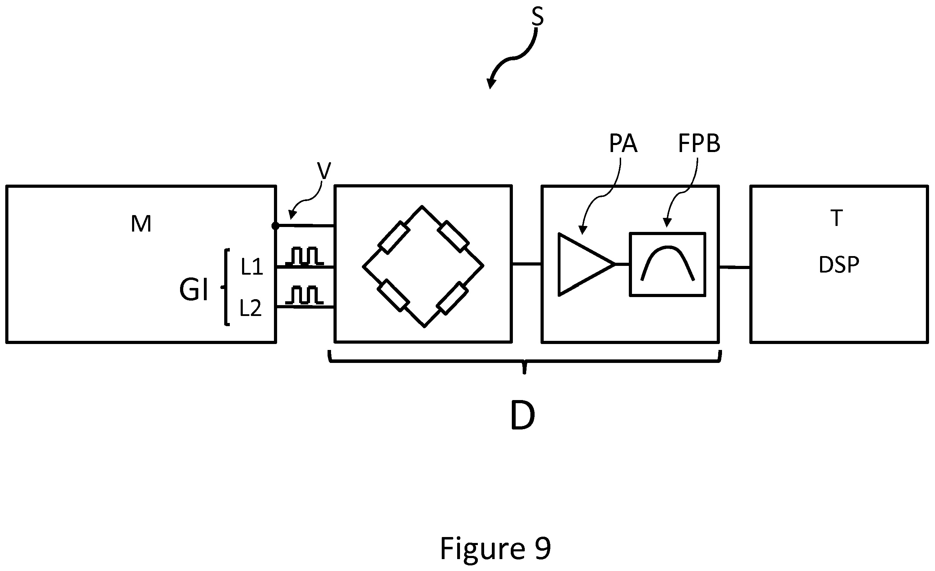

La figure 9 montre un exemple de mise en œuvre du système S selon l'invention en cas d'acquisition digitale directe et reconstruction digitale du signal non bruité.

Les moyens de modulation M génèrent un signal V d'alimentation ainsi que deux signaux périodiques L1 et L2 de fréquence f et d'impulsion de largeur ajustable. La fréquence f typique pour des GMR est autour de 100kHz. Pour des TMRs de petite taille elle peut aller jusqu'à 10MHz Le signal V est une tension continue qui alimente le pont GMR ou TMR. Les signaux périodiques L1 et L2 alimentent les lignes de courant 403, 404. Une valeur typique de largeur d'impulsion est 50% du cycle total. Les deux impulsions sont en phase. En sortie du pont, un preamplificateur PA bas bruit ainsi qu'un filtre FPB coupant les fréquences au-dessus de f et bien en dessous conditionne le signal qui est acquis, converti numériquement et traité par les moyens de traitement numérique DSP.

Les moyens de modulation M selon le mode de réalisation 9 comprennent par exemple un générateur de tension continue V et un générateur d'impulsions ou un générateur de fonctions GI.

Le préamplificateur très bas bruit PA doit avoir une bande passante d'au moins 5 fois la vitesse de commutation.

Les moyens de traitement numérique du signal DSP réalisent une acquisition très rapide typiquement à une fréquence d'échantillonnage autour de 10 MHz. Le signal est acquis directement en sortie du filtre FPB. Dans ce cas, tout le traitement se fait de façon digitale. Les points après chaque transition de champ appliqué sont moyennés. On reconstruit ainsi les deux courbes M1 et M2. Ces deux courbes sont ensuite soustraites pour obtenir le signal non bruité.

Avantageusement, ce mode de réalisation est facile à mettre en œuvre, grâce à l'utilisation des moyens de traitement numérique du signal DSP.

D'autres modes de réalisation reposent sur l'utilisation de moyens de traitement T analogique du signal.

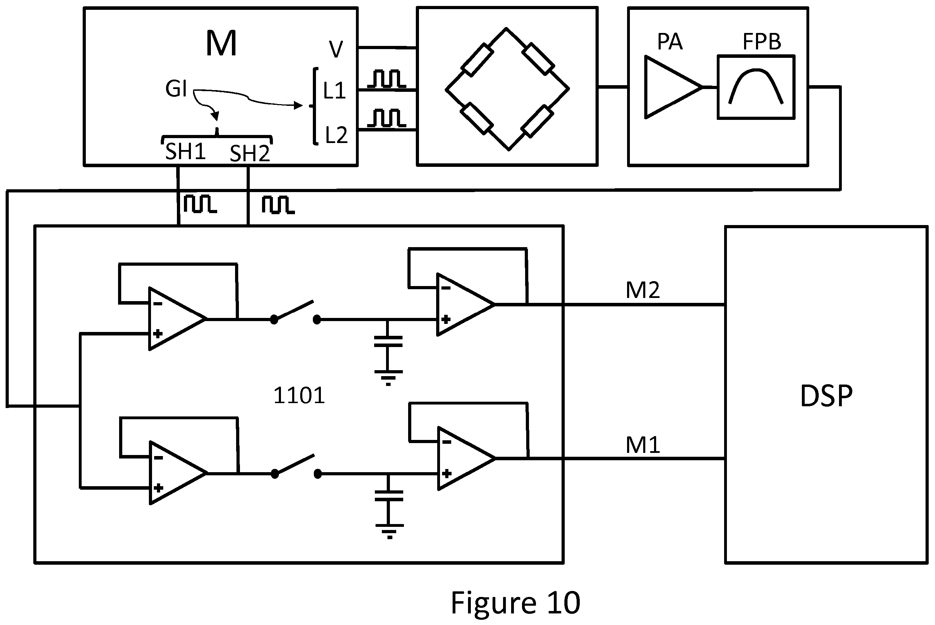

La figure 10 montre un exemple de schéma électrique permettant d'obtenir les deux courbes indépendantes M1 et M2 de façon analogique et une combinaison linéaire réalisée digitalement grâce aux moyens de traitement numérique DSP. En plus des modules déjà présents sur la figure 9, un double Sample & Hold 1101 est inséré. Il est commandé par les moyens de modulation M qui génèrent à ce moment 4 signaux. Deux signaux, L1 et L2, sont destinés aux lignes de courant du pont selon la figure 4 et deux signaux de largeur d'impulsions plus faibles 40% environ et en opposition de phase sont envoyés aux Sample & Hold 1101. Ainsi les deux S&H 1101 séparent les signaux mesurés lorsque les capteurs magnéto-résistifs ne sont pas saturées, mesure M1, et lorsque les capteurs magnéto-résistifs sont saturées, mesure M2. Les deux signaux M1 et M2 sont stockés, convertis et soustraits pour obtenir le signal non bruité. Ces opérations de stockage et soustraction des mesures M1 et M2 sont réalisées par les moyens de traitement numérique du signal DSP.

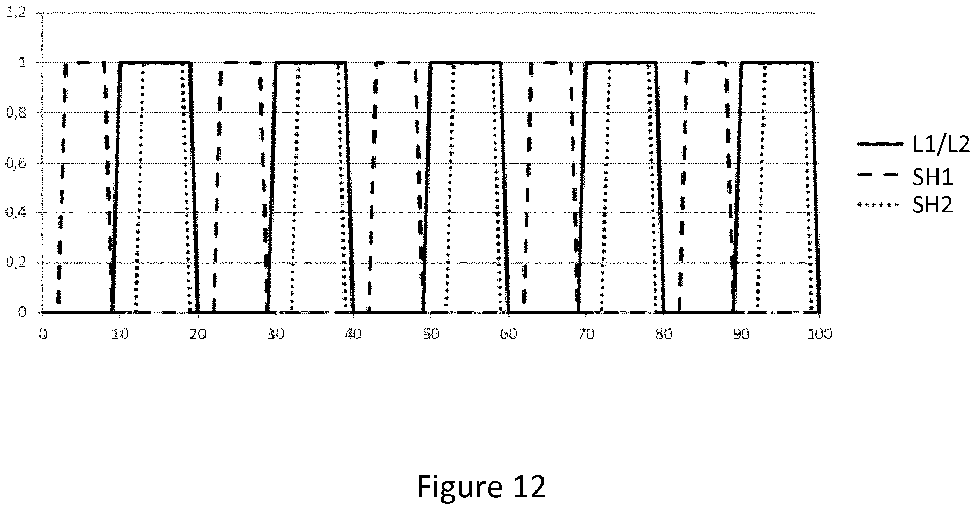

Plus particulièrement, le fonctionnement des deux circuits S&H 1101 est expliqué en relation à la figure 12 qui montre les signaux générés par le générateur de fonctions GI.

Le générateur de fonctions a le rôle d'une horloge générale à haute fréquence f typiquement 1MHz et génère trois signaux L1/L2, SH1, SH2. Le signal L1/L2 pilote la mise en place de la commutation courant nul-courant fort et permet de passer du mode détection au mode saturé. Le signal SH1 pilote un premier S&H 1101, le signal SH2 pilote le deuxième S&H 1101.

La figure 12 montre qu'un premier circuit S&H est en mode acquisition pendant l'absence de courant dans les lignes de courant, à savoir quand le signal de L1/L2 est nul. Ce premier circuit S&H permet de remonter à la mesure M1. Au contraire, le deuxième circuit S&H est en mode acquisition quand un courant circule dans les lignes de courant, à savoir quand le signal L1/L2 est non nul. Ce deuxième circuit S&H permet de remonter à la mesure M2, contenant essentiellement les fluctuations de résistance dues au bruit basse fréquence.

La première configuration des moyens de modulations M correspond à l'absence de signal L1/L2 : les capteurs magnéto-résistifs sont dans la zone de sensibilité. La deuxième configuration des moyens de modulation M correspond à la présence du signal L1/L2 : les capteurs magnéto-résistifs sont dans la zone de saturation.

Avantageusement, cette façon de piloter les circuits S&H permet de séparer les mesures M1 et M2 en utilisant une électronique simple à réaliser et de faible coût.

Le décalage temporel entre le signal L1/L2 et les deux signaux SH1 et SH2 est tel que les circuits S&H sont mis en mode acquisition après un petit temps en fin de commutation et en mode mémoire avant la commutation suivante comme montré sur la figure 12.

Avantageusement, ce décalage temporel permet d'écarter les transitoires qui suivent une commutation et de rendre plus précise l'élimination du bruit basse fréquence.

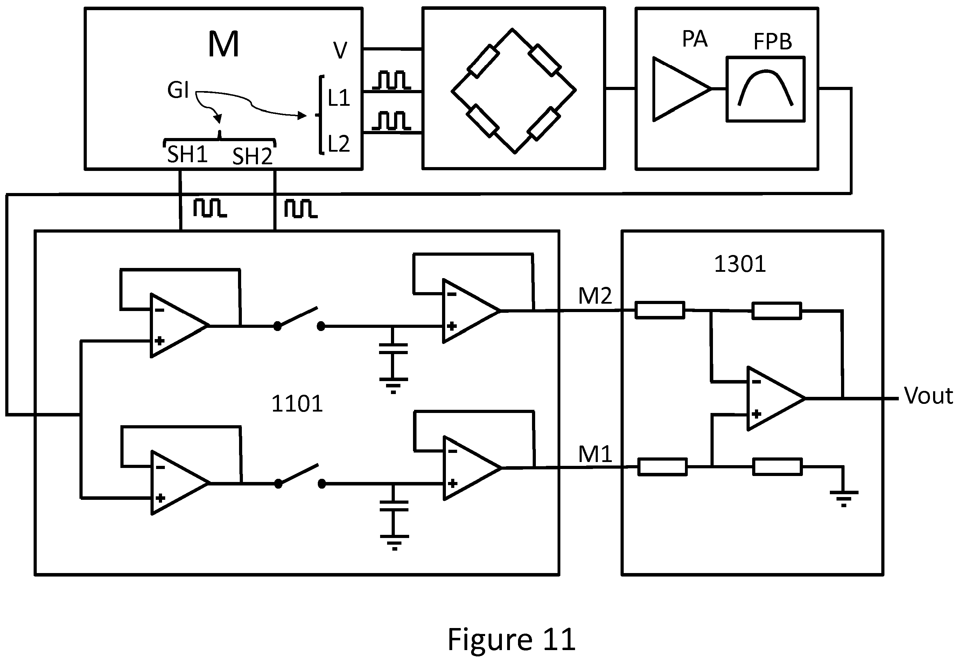

La figure 11 montre un troisième exemple de réalisation du système S selon l'invention, avec une étape de traitement du signal entièrement analogique. A la différence du dispositif de la figure 10, cette fois les moyens de traitement numérique du signal DSP sont remplacés par un circuit soustracteur 1301 capable de réaliser la soustraction des deux mesures M2 et M1 de façon analogique.

Avantageusement le système de la figure 11 est un système totalement analogique et potentiellement intégrable au niveau du capteur rendant transparent ces étapes de modulation et soustraction pour l'utilisateur.

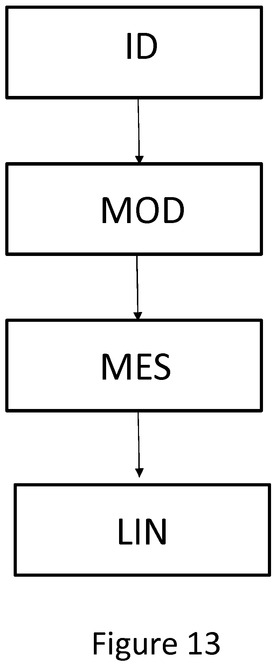

La figure 13 montre les étapes du procédé de mise en œuvre du système S selon l'invention.

Lors d'une première étape ID, les deux points de fonctionnement 201 et 202 de l'au moins un capteur magnéto-résistifs faisant partie du dispositif D de mesure du champ extérieur B dont choisis. Les points 201 et 202 sont choisis de sorte à avoir deux sensibilités au champ magnétique extérieur B très différentes. La sensibilité Ssat au deuxième point de fonctionnement est très faible ou nulle.

Lors de la deuxième étape MOD les moyens de modulation M sont utilisés pour faire basculer l'au moins un capteur magnéto-résistif C du premier point de fonctionnement 201 ayant la première sensibilité S1 au deuxième point de fonctionnement 202 ayant la deuxième sensibilité Ssat et du deuxième point de fonctionnement 202 au premier point de fonctionnement 201.

Lors de l'étape MES, la réponse des capteurs magnéto-résistifs du dispositif D dans la zone de sensibilité et dans la zone de saturation est enregistrée, la modulation de la sensibilité des capteurs magnéto-résistifs étant toujours en cours. La réponse des capteurs magnéto-résistifs dans la zone de saturation, ou mesure M2, contient essentiellement les fluctuations de résistance dues au bruit basse fréquence. La réponse des capteurs magnéto-résistifs dans la zone de sensibilité, ou mesure M1, contient les variations de résistances due aux variations du champ magnétique extérieur, en plus des fluctuations dues au bruit base fréquence. On obtient ainsi deux courbes dépendant du temps et indépendantes.

Il est donc possible, lors de l'étape LIN, de réaliser une combinaison linéaire des mesures M1 et M2 pour obtenir le signal non bruité et éventuellement une courbe donnant uniquement les fluctuations de résistances internes.

Selon un mode de réalisation, la combinaison linéaire de l'étape LIN consiste à soustraire les deux mesures M1 et M2.

Selon un autre mode de réalisation, lors de l'étape LIN les mesures M1 et M2 sont combinées linéairement selon une formule de type M1 - α M2. Le paramètre α dépend essentiellement de la sensibilité résiduelle lors de la mesure M2. Si celle-ci est nulle, α est nul sinon il sera environ égal au rapport de sensibilité.

Selon un mode de réalisation du procédé selon l'invention, la fréquence de modulation de la sensibilité des capteurs magnéto-résistifs est supérieure à la fréquence 101 à laquelle le bruit basse fréquence devient inférieur au bruit thermique associé aux capteurs magnéto-résistifs.

Selon un mode de réalisation du procédé, la fréquence de modulation de la sensibilité du capteur est au moins deux fois supérieure à la fréquence 101 à laquelle le bruit basse fréquence devient inférieur au bruit thermique associé aux capteurs magnéto-résistifs.

L'étape MES peut être réalisée à l'aide du dispositif de mesure D. Le dispositif D peut être réalisé selon l'une des configurations illustrées en relation au système S selon l'invention.

Les étapes MES et LIN peuvent être réalisée à l'aide des moyens de traitement de signal T. Les moyens de traitement T peuvent être numériques, analogiques ou en partie numériques et en parties analogiques selon l'une des configurations expliquées en relation au système S selon l'invention.

## Revendications

1. Système (S) de suppression du bruit basse fréquence de capteurs magnéto-résistifs, ledit système (S) de suppression comprenant un dispositif (D) de mesure d'un champ magnétique (B) et des moyens de modulation (M), ledit système (S) de suppression comprend :
- Ledit dispositif (D) comprenant au moins un capteur (C) magnéto-résistif, ledit capteur (C) magnéto-résistif ayant une première sensibilité (S1) à un premier point de fonctionnement (201) et une deuxième sensibilité (Ssat) à un deuxième point de fonctionnement (202), la sensibilité (S1) au premier point de fonctionnement étant élevée et la sensibilité (Ssat) au deuxième point de fonctionnement étant faible ou nulle;
ledit système étant **caractérisé en ce qu'**il comprend en outre:
- Les moyens de modulation (M) étant adaptés pour faire basculer le capteur magnéto-résistif (C) du premier point de fonctionnement (201) au deuxième point de fonctionnement (202) et du deuxième point de fonctionnement (202) au premier point de fonctionnement, lesdits moyens de modulation (M) ayant une première configuration correspondant au premier point de fonctionnement (201) et une deuxième configuration correspondant au deuxième point de fonctionnement (202) ; et
- Des moyens (T) de traitement du signal issus du dispositif (D) de mesure d'un champ magnétique (B), lesdits moyens (T) de traitement étant adaptés pour réaliser une combinaison linéaire d'une première réponse (M1) du dispositif de mesure (D) en présence du champ magnétique (B) au premier point de fonctionnement (S1) correspondant à la première configuration des moyens de modulation (M) et une deuxième réponse (M2) du dispositif de mesure (D) en présence du champ magnétique (B) au deuxième point de fonctionnement (Ssat) correspondant à la deuxième configuration des moyens de modulation (M).

2. Système (S) de suppression du bruit basse fréquence de capteurs magnéto-résistifs selon la revendication précédente **caractérisé en ce que** le dispositif (D) de mesure d'un champ magnétique (B) comprend deux capteurs magnéto-résistifs (301, 302) disposés selon un montage en demi-pont et un préamplificateur (PA) bas bruit, les deux capteurs magnéto-résistifs ayant une réponse au champ magnétique inversée, le montage en demi-pont comprenant un premier bras (B1) et un deuxième bras (B2), les deux bras étant connectés en parallèle, chacun de bras comprenant une résistance (R) et un des capteurs magnéto-résistifs (301,302), le montage en demi-pont comprenant en outre une première (V+) et une deuxième (V-) sortie, les deux sorties étant connectées au préamplificateur (PA) bas bruit, chaque sortie (V+, V-) étant le point de jonction entre une des résistances (R) et un des capteurs magnéto-résistifs (301, 302).

3. Système (S) de suppression du bruit basse fréquence de capteurs magnéto-résistifs selon la revendication précédente **caractérisé en ce que** le système de mesure (D) comprend une source tension continue (V) pour l'alimentation du montage en demi-pont, la tension continue (V) étant connectée au point de jonction entre le deux résistances (R) ou au point de jonction entre les deux capteurs magnéto-résistifs (301, 302).

4. Système (S) de suppression du bruit basse fréquence de capteurs magnéto-résistifs selon la revendication 1 **caractérisé en ce que** le dispositif de mesure (D) comprend un premier (401, 401a) et un deuxième (402, 402a) couple de capteurs magnéto-résistifs et un préamplificateur (PA) bas bruit, les capteurs du premier couple (401, 401a) ayant une réponse inversée par rapport aux capteurs du deuxième couple (402, 402a), les capteurs magnéto-résistifs (401,401a, 402, 402a) étant disposés selon un montage en pont, le montage en pont comprenant un premier bras (B1) et un deuxième bras (B2), les deux bras étant connectés en parallèle, chacun de bras comprenant un capteur magnéto-résistif du premier couple (401,401a) et un capteur magnéto-résistif du deuxième couple (402, 402a), le montage en pont comprenant en outre une première (V+) et une deuxième (V-) sortie, les deux sorties étant connectées au préamplificateur bas bruit, chaque sortie (V+, V-) étant le point de jonction entre un capteur magnéto-résistif du premier couple (401, 401a) et un capteur magnéto-résistif du deuxième couple (402, 402a).

5. Système (S) de suppression du bruit basse fréquence de capteurs magnéto-résistifs selon la revendication précédente **caractérisé en ce que** le système de mesure (D) comprend une source de tension continue (V) pour l'alimentation du montage en pont, la source de tension continue (V) étant connectée à un point de jonction entre un capteur magnéto-résistif du premier couple et un capteur magnéto-résistif du deuxième couple.

6. Système (S) de suppression du bruit basse fréquence de capteurs magnéto-résistifs selon l'une des revendications précédentes **caractérisé en ce que** le dispositif (D) de mesure comprend des lignes de courant (301, 302, 403, 404) pour appliquer un champ magnétique dans le plan des couches des capteurs magnéto-résistifs, de sorte qu'en présence du courant dans les lignes chaque capteur magnéto-résistif (C) est au deuxième point de fonctionnement (202) et en absence de courant dans les lignes chaque capteur magnéto-résistif (C) est au premier point de fonctionnement (201).

7. Système (S) de suppression du bruit basse fréquence de capteurs magnéto-résistifs selon l'une des revendications précédentes, **caractérisé en ce que** les moyens de modulation (M) comprennent une horloge générale à haute fréquence pour la génération d'un signal (L1/L2) de commutation entre le premier point de fonctionnement (201) et le deuxième point de fonctionnement (202).

8. Système (S) de suppression du bruit basse fréquence selon l'une des revendications précédentes **caractérisé en ce que** le signal de commutation (L1/L2) comprend des impulsions de courant circulant dans les lignes de courant (301, 302, 403, 404) pour la commutation de chaque capteur magnéto-résistif entre le premier point de fonctionnement (201) et le deuxième point de fonctionnement (202).

9. Système (S) de suppression du bruit basse fréquence de capteurs magnéto-résistifs selon l'une des revendications 1 à 8 **caractérisé en ce que** les moyens de traitement (T) du signal issu du dispositif (D) de mesure d'un champ magnétique (B) comprennent :
- Un premier circuit Sample and Hold destiné à enregistrer le signal (M1) mesuré par le dispositif (D) de mesure au premier point de fonctionnement (201) ;
- Un deuxième circuit Sample and Hold destiné à enregistrer le signal (M2) mesuré par le dispositif (D) de mesure au deuxième point de fonctionnement (202) ;
- Un système d'acquisition numérique (DSP) ou analogique (1301) pour la combinaison linéaire des signaux issus du premier et deuxième circuit Sample and Hold.

10. Procédé (1) de suppression de bruit basse fréquence associé à la mesure d'un champ magnétique (B) par un dispositif de mesure (D) comprenant au moins un capteur (C) magnéto-résistif, ledit procédé comprenant les étapes suivantes :
- Identifier (ID) un premier (201) et un deuxième (202) point de fonctionnement du capteur magnéto-résistif, le capteur magnéto-résistif ayant une première sensibilité (S1) au premier point de fonctionnement (201) et une deuxième sensibilité (Ssat) au deuxième point de fonctionnement (202), la sensibilité (S1) au premier point de fonctionnement étant élevée et la sensibilité (Ssat) au deuxième point de fonctionnement étant faible ou nulle ;
ledit procédé étant en outre **caractérisé par** les étapes suivantes:
- Moduler (MOD) la sensibilité du capteur (C) magnéto-résistif en faisant basculer le capteur magnéto-résistif (C) du premier (201) point de fonctionnement ayant la première sensibilité (S1) au deuxième (202) point de fonctionnement ayant la deuxième sensibilité (Ssat) et du deuxième point de fonctionnement (202) au premier point de fonctionnement (201) ;
- Lors de la modulation (MOD), mesurer (MES) une première réponse (M1) du dispositif de mesure (D) en présence du champ magnétique (B) au premier point de fonctionnement (S1) et une deuxième réponse (M2) du dispositif de mesure (D) en présence du champ magnétique (B) au deuxième point de fonctionnement (Ssat) ;
- Calculer une combinaison linéaire (LIN) de la première réponse (M1) et de la deuxième réponse (M2) du système de mesure (D).

## Patentansprüche

1. System (S) zur Unterdrückung des Niederfrequenzrauschens von magnetoresistiven Sensoren, wobei dieses System (S) eine Vorrichtung (D) zur Messung eines Magnetfelds (B) und Modulationsmittel (M) sowie Folgendes umfasst
- Die Vorrichtung (D), die mindestens einen magnetoresistiven Sensor (C) umfasst, wobei der magnetoresistive Sensor (C) eine erste Empfindlichkeit (S1) an einem ersten Betriebspunkt (201) und eine zweite Empfindlichkeit (Ssat) an einem zweiten Betriebspunkt (202) aufweist, wobei die Empfindlichkeit (S1) am ersten Betriebspunkt hoch ist und die Empfindlichkeit (Ssat) am zweiten Betriebspunkt niedrig oder null ist; wobei das System **dadurch gekennzeichnet ist, dass** es ferner umfasst:
- Die Modulationsmittel (M), die geeignet sind, den magnetoresistiven Sensor (C) vom ersten Betriebspunkt (201) zum zweiten Betriebspunkt (202) und vom zweiten Betriebspunkt (202) zum ersten Betriebspunkt umzuschalten, wobei die Modulationsmittel (M) eine erste Konfiguration entsprechend dem ersten Betriebspunkt (201) und eine zweite Konfiguration entsprechend dem zweiten Betriebspunkt (202) aufweisen; und
- Mittel (T) zur Verarbeitung des Signals, das von der Vorrichtung (D) zur Messung eines Magnetfelds (B) stammt, wobei die Verarbeitungsmittel (T) geeignet sind, eine lineare Kombination aus einer ersten Antwort (M1) der Messvorrichtung (D) in Gegenwart des Magnetfelds (B) am ersten Betriebspunkt (51), der der ersten Konfiguration der Modulationsmittel (M) entspricht, und einer zweiten Antwort (M2) der Messvorrichtung (D) in Gegenwart des Magnetfelds (B) am zweiten Betriebspunkt (Ssat), der der zweiten Konfiguration der Modulationsmittel (M) entspricht, zu realisieren.

2. System (S) zur Unterdrückung des Niederfrequenzrauschens von magnetoresistiven Sensoren nach dem vorhergehenden Anspruch, **dadurch gekennzeichnet, dass** die Vorrichtung (D) zur Messung eines Magnetfelds (B) zwei magnetoresistive Sensoren (301, 302), die in einer Halbbrückenanordnung angeordnet sind, und einen rauscharmen Vorverstärker (PA) umfasst, wobei die beiden magnetoresistiven Sensoren eine umgekehrte Magnetfeldantwort haben und die Halbbrückenanordnung einen ersten Arm (B1) und einen zweiten Arm (B2) umfasst, wobei die beiden Arme parallel geschaltet sind und jeder der Arme einen Widerstand (R) und einen der magnetoresistiven Sensoren (301, 302) umfasst, wobei die Halbbrückenanordnung ferner einen ersten (V+) und einen zweiten (V-) Ausgang umfasst und beide Ausgänge mit dem rauscharmen Vorverstärker (PA) verbunden sind, wobei jeder Ausgang (V+, V-) der Verbindungspunkt zwischen einem der Widerstände (R) und einem der magnetoresistiven Sensoren (301, 302) ist.

3. System (S) zur Unterdrückung des Niederfrequenzrauschens von magnetoresistiven Sensoren nach dem vorhergehenden Anspruch, **dadurch gekennzeichnet, dass** das Messsystem (D) eine Gleichspannungsquelle (V) zur Versorgung der Halbbrückenanordnung umfasst, wobei die Gleichspannung (V) mit dem Verbindungspunkt zwischen den beiden Widerständen (R) oder mit dem Verbindungspunkt zwischen den beiden magnetoresistiven Sensoren (301, 302) verbunden ist.

4. System (S) zur Unterdrückung des Niederfrequenzrauschens von magnetoresistiven Sensoren nach Anspruch 1, **dadurch gekennzeichnet, dass** die Messvorrichtung (D) ein erstes (401, 401a) und ein zweites (402, 402a) Paar von magnetoresistiven Sensoren und einen rauscharmen Vorverstärker (PA) umfasst, wobei die Sensoren des ersten Paars (401, 401a) eine umgekehrte Antwort in Bezug auf die Sensoren des zweiten Paars (402, 402a) haben und die magnetoresistiven Sensoren (401, 401a, 402, 402a) in einer Brückenschaltung angeordnet sind, wobei die Brückenschaltung einen ersten Arm (B1) und einen zweiten Arm (B2) umfasst, die beiden Arme parallel geschaltet sind und jeder der Arme einen magnetoresistiven Sensor des ersten Paars (401, 401a) und einen magnetoresistiven Sensor des zweiten Paars (402, 402a) umfasst, wobei die Brückenschaltung ferner einen ersten (V+) und einen zweiten (V-) Ausgang umfasst und beide Ausgänge mit dem rauscharmen Vorverstärker verbunden sind, wobei jeder Ausgang (V+, V-) der Verbindungspunkt zwischen einem magnetoresistiven Sensor des ersten Paares (401, 401a) und einem magnetoresistiven Sensor des zweiten Paares (402, 402a) ist.

5. System (S) zur Unterdrückung des Niederfrequenzrauschens von magnetoresistiven Sensoren nach dem vorhergehenden Anspruch, **dadurch gekennzeichnet, dass** das Messsystem (D) eine Gleichspannungsquelle (V) zur Versorgung der Brückenschaltung umfasst, wobei die Gleichspannungsquelle (V) an einen Verbindungspunkt zwischen einem magnetoresistiven Sensor des ersten Paares und einem magnetoresistiven Sensor des zweiten Paares angeschlossen ist.

6. System (S) zur Unterdrückung des Niederfrequenzrauschens von magnetoresistiven Sensoren nach einem der vorhergehenden Ansprüche, **dadurch gekennzeichnet, dass** die Messvorrichtung (D) Stromleitungen (301, 302, 403, 404) zum Anlegen eines Magnetfelds in der Ebene der Schichten der magnetoresistiven Sensoren umfasst, so dass bei Vorhandensein von Strom in den Leitungen jeder magnetoresistive Sensor (C) am zweiten Betriebspunkt (202) ist und bei Fehlen von Strom in den Leitungen jeder magnetoresistive Sensor (C) am ersten Betriebspunkt (201) ist.

7. System (S) zur Unterdrückung des Niederfrequenzrauschens von magnetoresistiven Sensoren nach einem der vorhergehenden Ansprüche, **dadurch gekennzeichnet, dass** die Modulationsmittel (M) einen allgemeinen Hochfrequenztakt zur Erzeugung eines Signals (L1/L2) zum Umschalten zwischen dem ersten Betriebspunkt (201) und dem zweiten Betriebspunkt (202) umfassen.

8. System (S) zur Unterdrückung des Niederfrequenzrauschens nach einem der vorhergehenden Ansprüche, **dadurch gekennzeichnet, dass** das Schaltsignal (L1/L2) Stromimpulse umfasst, die in den Stromleitungen (301, 302, 403, 404) zum Umschalten jedes magnetoresistiven Sensors zwischen dem ersten Betriebspunkt (201) und dem zweiten Betriebspunkt (202) fließen.

9. System (S) zur Unterdrückung des Niederfrequenzrauschens von magnetoresistiven Sensoren nach einem der Ansprüche 1 bis 8, **dadurch gekennzeichnet, dass** die Mittel (T) zur Verarbeitung des Signals, das von der Vorrichtung (D) zur Messung eines Magnetfelds (B) stammt, umfassen:
- Eine erste Sample-and-Hold-Schaltung zum Aufzeichnen des Signals (M1), das von der Messvorrichtung (D) am ersten Betriebspunkt (201) gemessen wird;
- Eine zweite Sample-and-Hold-Schaltung zum Aufzeichnen des Signals (M2), das von der Messvorrichtung (D) am zweiten Betriebspunkt (202) gemessen wird;
- Ein digitales (DSP) oder analoges (1301) Erfassungssystem für die lineare Kombination von Signalen aus der ersten und zweiten Sample-and-Hold-Schaltung.

10. Verfahren (1) zur Unterdrückung von Niederfrequenzrauschen, das mit der Messung eines Magnetfelds (B) durch eine Messvorrichtung (D) verbunden ist, mindestens einen magnetoresistiven Sensor (C) umfassend, wobei das Verfahren die folgenden Schritte umfasst:
- Identifizieren (ID) eines ersten (201) und eines zweiten (202) Betriebspunktes des magnetoresistiven Sensors, wobei der magnetoresistive Sensor eine erste Empfindlichkeit (S1) am ersten Betriebspunkt (201) und eine zweite Empfindlichkeit (Ssat) am zweiten Betriebspunkt (202) aufweist, wobei die Empfindlichkeit (S1) am ersten Betriebspunkt hoch ist und die Empfindlichkeit (Ssat) am zweiten Betriebspunkt niedrig oder null ist; wobei das Verfahren ferner durch die folgenden Schritte gekennzeichnet ist:
- Modulieren (MOD) der Empfindlichkeit des magnetoresistiven Sensors (C) durch Umschalten des magnetoresistiven Sensors (C) vom ersten Betriebspunkt (201) mit der ersten Empfindlichkeit (S1) zum zweiten Betriebspunkt (202) mit der zweiten Empfindlichkeit (Ssat) und vom zweiten Betriebspunkt (202) zum ersten Betriebspunkt (201);
- Bei der Modulation (MOD) Messen (MES) einer ersten Antwort (M1) der Messvorrichtung (D) bei Vorhandensein des Magnetfelds (B) am ersten Betriebspunkt (S1) und einer zweiten Antwort (M2) der Messvorrichtung (D) bei Vorhandensein des Magnetfelds (B) am zweiten Betriebspunkt (Ssat);
- Berechnen einer Linearkombination (LIN) der ersten Antwort (M1) und der zweiten Antwort (M2) des Messsystems (D).

## Claims

1. System (S) for suppressing low frequency noise of magnetoresistive sensors, said suppression system (S) including a device (D) for measuring a magnetic field (B) and modulation means (M), said system (S) for suppressing comprising:
- said device (D) including at least one magnetoresistive sensor (C), said magnetoresistive sensor (C) having a first sensitivity (S1) at a first operating point (201) and a second sensitivity (Ssat) at a second operating point (202), the sensitivity (S1) at the first operating point being high and the sensitivity (Ssat) at the second operating point being low or zero;
said system being **characterized in that** it further comprises:
- the modulation means (M) being suited to switching the magnetoresistive sensor (C) from the first operating point (201) to the second operating point (202) and from the second operating point (202) to the first operating point, said modulation means (M) having a first configuration corresponding to the first operating point (201) and a second configuration corresponding to the second operating point (202);
- Means (T) for processing the signal derived from the device (D) for measuring a magnetic field (B), said processing means (T) being suited to making a linear combination of a first response (M1) of the measuring device (D) in the presence of the magnetic field (B) at the first operating point (S1) corresponding to the first configuration of the modulation means (M) and a second response (M2) of the measuring device (D) in the presence of the magnetic field (B) at the second operating point (Ssat) corresponding to the second configuration of the modulation means (M).

2. System (S) for suppressing low frequency noise of magnetoresistive sensors according to the preceding claim **characterised in that** the device (D) for measuring a magnetic field (B) includes two magnetoresistive sensors (301, 302) arranged according to a half-bridge arrangement and a low noise preamplifier (PA), the two magnetoresistive sensors having an inverse response to the magnetic field, the half-bridge arrangement including a first arm (B1) and a second arm (B2), the two arms being connected in parallel, each of the arms including a resistor (R) and one of the magnetoresistive sensors (301,302), the half-bridge arrangement further including a first (V+) and a second (V-) output, the two outputs being connected to the low noise preamplifier (PA), each output (V+, V-) being the junction point between one of the resistors (R) and one of the magnetoresistive sensors (301, 302).

3. System (S) for suppressing low frequency noise of magnetoresistive sensors according to the preceding claim **characterised in that** the measuring system (D) includes a DC voltage source (V) for the supply of the half-bridge arrangement, the DC voltage (V) being connected to the junction point between the two resistors (R) or to the junction point between the two magnetoresistive sensors (301, 302).

4. System (S) for suppressing low frequency noise of magnetoresistive sensors according to claim 1 **characterised in that** the measuring device (D) includes a first (401, 401a) and a second (402, 402a) pair of magnetoresistive sensors and a low noise preamplifier (PA), the sensors of the first pair (401, 401a) having an inverse response compared to the sensors of the second pair (402, 402a), the magnetoresistive sensors (401,401a, 402, 402a) being arranged according to a bridge arrangement, the bridge arrangement including a first arm (B1) and a second arm (B2), the two arms being connected in parallel, each of the arms including a magnetoresistive sensor of the first pair (401,401a) and a magnetoresistive sensor of the second pair (402, 402a), the bridge arrangement further including a first (V+) and a second (V-) output, the two outputs being connected to the low noise preamplifier, each output (V+, V-) being the junction point between a magnetoresistive sensor of the first pair (401, 401a) and a magnetoresistive sensor of the second pair (402, 402a).

5. System (S) for suppressing low frequency noise of magnetoresistive sensors according to the preceding claim **characterised in that** the measuring system (D) includes a DC voltage source (V) for the supply of the bridge arrangement, the DC voltage source (V) being connected to a junction point between a magnetoresistive sensor of the first pair and a magnetoresistive sensor of the second pair.

6. System (S) for suppressing low frequency noise of magnetoresistive sensors according to one of the preceding claims **characterised in that** the measuring device (D) includes current lines (301, 302, 403, 404) to apply a magnetic field in the plane of the layers of the magnetoresistive sensors, such that in the presence of current in the lines each magnetoresistive sensor (C) is at the second operating point (202) and in the absence of current in the lines each magnetoresistive sensor (C) is at the first operating point (201).

7. System (S) for suppressing low frequency noise of magnetoresistive sensors according to one of the preceding claims, **characterised in that** the modulation means (M) include a high frequency master clock for the generation of a switching signal (L1/L2) between the first operating point (201) and the second operating point (202).

8. System (S) for suppressing low frequency noise according to one of the preceding claims **characterised in that** the switching signal (L1/L2) includes current pulses circulating in the current lines (301, 302, 403, 404) for the switching of each magnetoresistive sensor between the first operating point (201) and the second operating point (202).

9. System (S) for suppressing low frequency noise of magnetoresistive sensors according to one of claims 1 to 8 **characterised in that** the means for processing (T) the signal derived from the device (D) for measuring a magnetic field (B) include:
- A first Sample and Hold circuit intended to record the signal (M1) measured by the measuring device (D) at the first operating point (201);
- A second Sample and Hold circuit intended to record the signal (M2) measured by the measuring device (D) at the second operating point (202);
- A digital (DSP) or analogue (1301) acquisition system for the linear combination of the signals derived from the first and second Sample and Hold circuits.

10. Method (1) for suppressing low frequency noise associated with the measurement of a magnetic field (B) by a measuring device (D) including at least one magnetoresistive sensor (C), said method including the following steps:
- Identifying (ID) a first (201) and a second (202) operating point of the magnetoresistive sensor, the magnetoresistive sensor having a first sensitivity (S1) at the first operating point (201) and a second sensitivity (Ssat) at the second operating point (202), the sensitivity (S1) at the first operating point being high and the sensitivity (Ssat) at the second operating point being low or zero;
Said method being further **characterized by** the following steps:
- Modulating (MOD) the sensitivity of the magnetoresistive sensor (C) by switching the magnetoresistive sensor (C) from the first operating point (201) having the first sensitivity (S1) to the second operating point (202) having the second sensitivity (Ssat) and from the second operating point (202) to the first operating point (201);
- During the modulation (MOD), measuring (MES) a first response (M1) of the measuring device (D) in the presence of the magnetic field (B) at the first operating point (S1) and a second response (M2) of the measuring device (D) in the presence of the magnetic field (B) at the second operating point (Ssat);
- Calculating a linear combination (LIN) of the first response (M1) and the second response (M2) of the measuring system (D).
